# EUROPEAN PATENT APPLICATION

(11) **EP 1 286 170 A1**
(43) Date of publication of application: **26.02.2003**
(21) Application number: 01306895.2
(22) Date of filing: 14.08.2001
(51) Int. Cl.: G01R 31/3185

(54) **Scan flip-flop with bypass of the memory cell of the flipflop**

(71) Applicant: LUCENT TECHNOLOGIES INC., Murray Hill, New Jersey 07974-0636 (US)
(72) Inventor: Otto, Klaus-Holger, Nuernberg, D-90411 (DE); Rupprecht, Wolfgang, Igensdorf, D-91338 (DE); Schmid, Josef, Neumarkt, D-92318 (DE); Schuering, Timo Frithjof, D-90482 Nuernberg (DE); Smalla, Christoph, D-90491 Nuernberg (DE); Willecke, Roland, Stulln 92551 (DE)
(74) Representative: Sarup, David Alexander

(57) **Abstract**

The invention proposes to provide core scan chain functionality of an integrated circuit by providing at least one scan flip-flop (10), each having a functional layer between an input port (PI) and at least one output port (Q,QN) and a storage layer between a scan input port (SI) and one of at least one output port (Q,QN) constructed to be used within a scan chain, modifying said scan flip-flop (10) by adding a bypass to a non-inverted and separate scan output port (SO) and implementing each of such modified scan flip-flops in the integrated circuit by creating a scan chain using the scan input port (SI) and the scan output port (SO).
Additionally, delay measurement and characterization can be performed. Also improved resetting is possible to avoid power-peaks by a delayed distribution of the reset pulses.

## Description

The invention relates to a method for providing core scan functionality, to a scan flip-flop adapted for providing such functionality and an integrated circuit having such functionality.

Usually, the handling of integrated circuits (ICs) including application specific circuits (ASICs) and/or system on chips (SOCs) is a major challenge, as known by persons skilled in the art. In particular, the design, the implementation, the scan and/or ATPG (automatic test pattern generation) testability and/or the delay measuring of such complex digital integrated circuits are very important and skew sensitivity criteria have to be taken in consideration. Based thereon, principal problems concern in general to the resetting, setting and/or initializing of a complex circuit or complex device including such a circuit, to the implementation of scan features without introducing a negative impact on functionality or performance or to the provision of a long and preferably standardized delay path for measurement and/or characterization reasons.

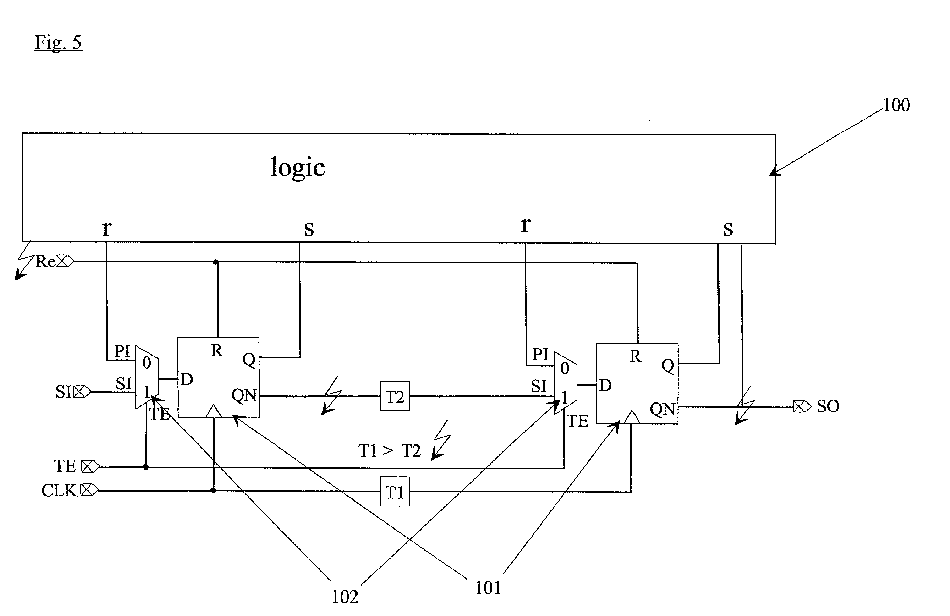

Current solutions for providing a scan chain for the testability of a complex ASIC/SOC/IC, in the following description generally referred-to as integrated circuit, i.e. IC, use standard scan flip-flops with synchronous or asynchronous set/reset functionality. Such a prior art solution using standard so-called muxed scan flip-flops is exemplary depicted in Fig. 5 of the accompanied drawings.

Regarding the sequential circuit of Fig. 5, there is a combinational logic 100 comprising response paths r and stimuli paths s and a storage layer comprising flip-flops 101 to form the functionality. For structured testing there is an extra test layer added which consists of scan multiplexers 102 controlled by a test enable pin TE. The respectively implemented scan multiplexers 102 together with storage elements 101 form the well-known muxed scan flip-flops.

However, the use of such a or a similar kind of solution may cause many problems, such as for example with regard to a global initialization and/or resetting (flash clear) in particular based on asynchronous, synchronous and/or scan resets, involving toggling of a hundred thousand or more of flip-flops within a short period in the order of nanoseconds, ground-bounces or noises, power issues and/or reliability problems. On these matters, a standard solution is not available besides the manually adjusting of delays accordingly.

Furthermore, since there is no long, standardized delay path defined, problems encounter especially with regard to the characterizing of a delay modeling flow and/or the measuring of the device quality on chip, e.g. to measure final process parameters of the integrated circuits used within a best case and worst case production process window. Such problems may be solved by the use of some vendor specific methods like methods using a so called NAND-tree and/or PROCMON-cell, i.e. a process monitor cell. However these methods usually need additional instances, some efforts for implementation, initialization and/or access as disclosed for example by Texas Instruments, "GS30 Design Manual and TDL Documentation" or LSI Logic, "Design Manual and Procmon Application Note". A cross-chip delay chain approach, as disclosed in document EP 1 301 472 with the title "Boundary scan delay chain for cross-chip delay measurement", using a boundary scan chain, in particular the boundary scan chain according to IEEE 1149.1, is covering however the IO-regions only.

Moreover, scan chain problems encounter based on using a scan path which is coupled to a functional path and/or involving inversions, for example if the QN-ports of the flip-flops 101 are used for a scan path according to Fig. 5. Additionally, inversions normally aggravate the debugging, in particular of scan problems. Moreover, scan chain problems are encountered based on a clock skew and hold time sensitivity, for example if clocks or timesets T1, T2 (Fig. 5) are in a wrong order. On these matters a known solution approach is called LSSD (level sensitive scan design), wherein the storage elements comprise special LSSD-elements and/or flip-flops which are designed in a full custom design style. However, such a methodology is producing some overhead, the elements needed may not be available in every vendor library and merely the scan problems can be solved.

An object of the present invention is therefore to provide a possibility, which is new and considerably improved over the prior art, in particular for providing a core scan chain functionality that is substantially independent of vendors, technology and/or used development with a minimum of implementation effort and design time and with a significantly improved handling of integrated circuits to be tested.

The inventive solution of the object is achieved by a method, a scan flip-flop, an integrated circuit and a device incorporating the features of claim 1, 11, 19 and 22, respectively.

Advantageous and/or preferred refinements or embodiments are the subject matter of the respective dependent claims.

According to the invention it is proposed to provide at least one scan flip-flop, each having a functional layer between an input port and at least one output port and a storage layer between a scan input port and one of the at least one output port constructed to be used within a scan chain, to add a non-inverted and separate scan output port and to implement each scan flip-flop in the integrated circuit by creating a scan chain using the scan input port and the scan output port.

One of the most relevant advantages is, that the scan output port and hence the scan path in general is functionally decoupled, in particular with regard to any load and/or wiring delay. Moreover, preferably by using a scan flip-flop with an input port and a scan input port fed via a multiplexer controlled by a test enable pin and the additional and non-inverted scan output port adapted to create a core scan chain passing through said scan input port and said scan output port, a core scan chain may easily be provided using a plurality of inventive scan flip-flops connected in series with the respective preceding scan output port connected with the respective successive scan input port. Consequently, non-inverted signal paths can be ensured, thereby avoiding debugging, scan initializing and/or scan configuration problems. Moreover, since a respective scan output port and a respective scan input port may be directly connected in series and are functionally decoupled timing problems in the functional path due to scan wiring are significantly reduced.

However, it has to be mentioned, that not only one scan chain is possible but also several scan chains in parallel are possible (e.g. eight is default) depending on vendor and ATPG requirements.

According to a very preferred refinement, an additional combinational path between the scan input port and the scan output port of a respective scan flip-flop, preferably bypassing the storage layer, is implemented. Based thereon a delay chain is ensured that may include all scan flip-flops for providing a very long cross-chip delay chain. Consequently, the characterizing of the delay modeling flow and/or the measuring of the "device quality" of complex ASICs/SOCs/ICs is guarantied by providing a very simple access and initialization on tester, in system and/or in the field.

In particular for further increasing a safety margin concerning clock skew problems, the invention proposes according to a further improved embodiment, to connect the bypass and the storage layer with the scan output port via an additional multiplexer controlled by the test enable pin.

Practically, for guaranteeing a very easy implementation it is further suggested to connect that additional multiplexer with the storage layer via the already existing inverted output port, e.g. using a further inverter therebetween or using an inverted multiplexer.

According to a further preferred embodiment the inventive scan flip-flop is additionally provided with a gate for resetting and/or setting the scan flip-flop via that additional combinational path. In particular it is suggested to connect an associated reset and/or set test pin and the scan input port to a reset and/or set port of said flip-flop by means of an appropriate gate, for example by means of an AND-gate. Accordingly, by using the delay chain a delayed global asynchronous reset, set and/or initialization even of complex ASICs or SOCs is enabled that may be used for example for synchronous and/or asynchronous clocked microprocessors, digital signal processors and/or multi-clocked designs, such as telecommunication devices.

To further improve the easy handling of the global control of complex circuits the invention proposes to connect the scan input port of a scan flip-flop adapted to form the first flip-flop of a scan chain with the associated reset and/or set pin via a multiplexer controllable by the test enable pin. Moreover, the circuit may be analyzed for identifying internal and/or local resets to be clustered and/or disabled during scan test. Accordingly, any identified internal and/or local reset domain to be clustered and/or disabled during scan test is preferably connected with the associated reset and/or set pin by means of an associated test reset enable pin.

Advantageously, the reset, set and/or initialization timing can be varied simply by adding elements, such as load or delay elements from the library, and/or by bypassing using clusters similar to "carry-look-ahead" techniques for adders.

Thus, the synthesis of the inventive scan flip-flops within a complex integrated circuit or an electrical device comprising such an integrated circuit may be done with functional constraints and the scan chain routing may be done according to standard DFT (design for test)-rules, as known by a person skilled in the art.

Consequently, the preferred embodiments of the inventive approach provide standardized solutions for several problems, wherein a similar implementation is ensured for resetting and/or setting the flip-flops and/or high or low active control signals.

Subsequently, the invention is exemplary described in more detail, in particular on the bases of preferred refinements and with reference to the accompanied drawing, in which:
- Fig. 1: is a schematic diagram of a very preferred refinement comprising a advantageously modified scan flip-flop according to the invention,
- Fig. 2: is a schematic diagram of a further preferred refinement comprising a scan flip-flop according to the invention and adapted to be used for an integrated circuit having different reset domains,
- Fig. 3: is schematically depicting a scan chain using a plurality of scan flip-flops according to Fig. 1,
- Fig. 4: is a schematic timing diagram, representing the time behavior concerning a delay measurement and a global reset activation based on the scan chain of Fig. 3, and
- Fig. 5: is a schematic diagram of a prior art scan chain using standard prior art scan flip flops.

For the following description and for the attached set of claims ASICs, SOCs, and ICs are generally referred-to as integrated circuit. As known by a person skilled in the art, standard flip-flops are often incorporated in integrated circuits for scan testability reasons.

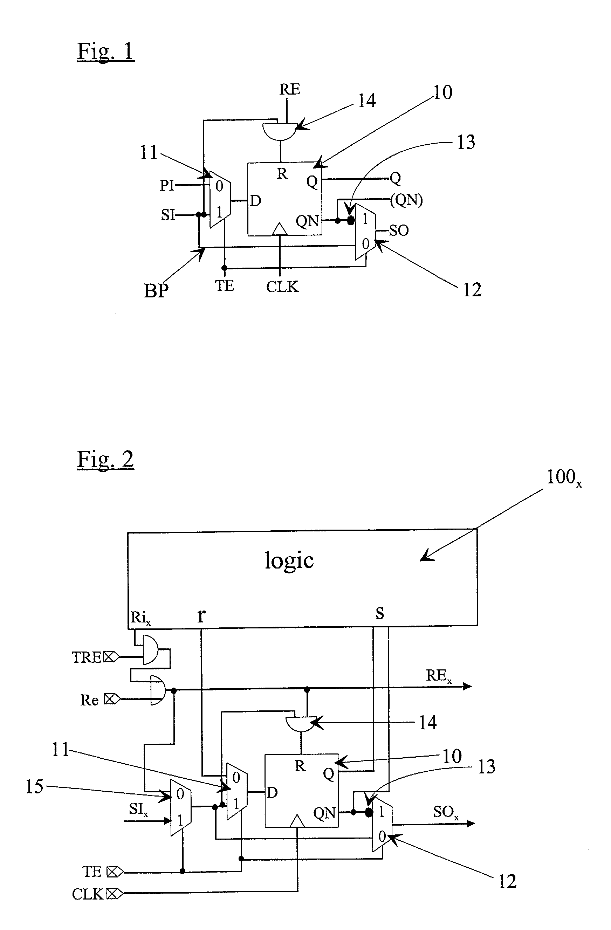

As can be seen from Fig. 1 schematically depicting a very preferred refinement of an inventive scan flip-flop comprising a standard flip-flop 10, in particular a D-flip-flop 10, e.g. a data type flip-flop or latch, forming the functionality and clocked by a clock signal CLK. For structured testing, a scan multiplexer 11 having a scan input port SI and a functional parallel input port PI is connected at its output to the input port D of the flip-flop 10 and is controlled by a test enable pin TE. In contradiction to a current standard scan flip-flop as used for example within the prior art circuit according to Fig. 5, the inventive scan flip-flop of Fig. 1 is provided with an associated separate scan output SO.

According to the exemplary embodiment, the separate scan output SO is designed as being the output of a second multiplexer 12, which also is controlled by the test enable pin TE. The first input of multiplexer 12 is connected with the inverted output port QN of the flip-flop 10 via an interconnected inverter means 13. The second input port of the multiplexer 12 is connected with the scan input port SI via a combinational path BP bypassing the storage layer and hence, forming a delay chain (from input SI) and a scan chain (from output QN).

Furthermore, the scan input port SI is connected together with a reset path RE via an AND-gate 14 to the reset port R of the flip-flop 10 for resetting the inventive scan flip-flop.

Accordingly, for entering the functional mode, both the test enable pin TE and the reset path RE are set to "0". As a result, the output port Q providing the functional path between the core of flip-flop 10 and an output buffer is in functional dependence on the input port PI, i.e. Q = f(PI). Moreover, due to the delay chain created by the bypass BP the information of the scan input port SI is obtained at the scan output port SO, i.e. SO = SI.

For entering the scan mode the reset path RE remains on "0" but the test enable pin TE is set to "1". Accordingly, the scan output port SO is equal to the output port Q and thus not inverted and in functional dependence on the scan input port SI, i.e. SO = Q = f(SI).

For entering the reset mode, the test enable pin TE is set to comply with the functional mode, i.e. is set to "0". By setting the scan input port SI to "0" and the reset path RE to "1" the reset mode is enabled.

Consequently, when changing the information of the scan input port SI from "0" to "1" that information is obtained at the scan output port SO with a delay based on the bypass BP. As a result, the output port Q is reset to "0" since the reset port R is activated.

Accordingly such an inventive scan flip-flop may be standardized and referred-to as being a DFC-SFF, i.e. a Delayed Flash Clear Scan Flip-Flop.

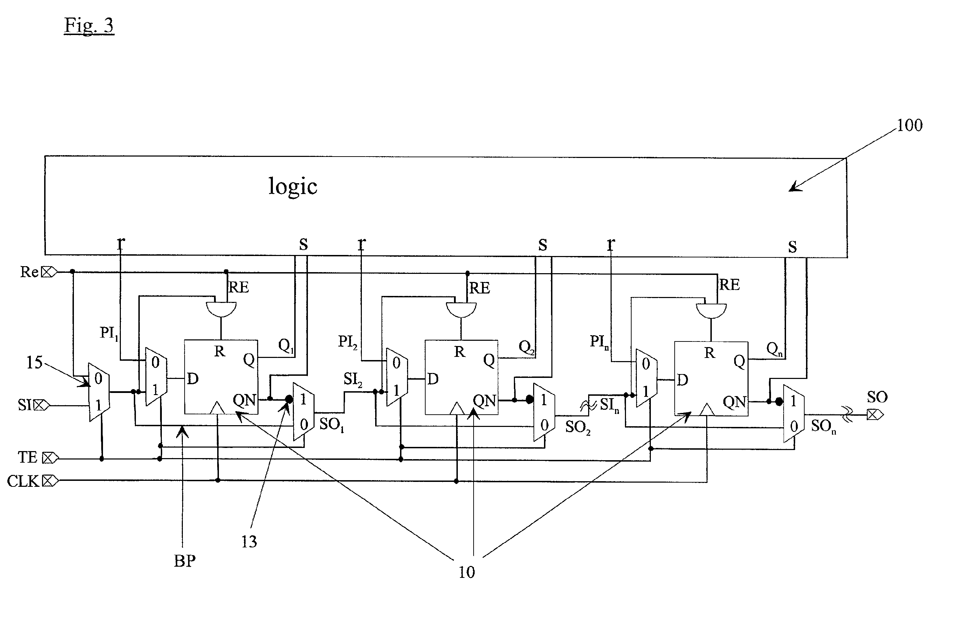

Moreover, by connecting a plurality of inventive scan flip-flops in series, in particular by connecting a respective preceding scan output port SOₙ₋₁ directly with the successive scan input port SIₙ a scan chain and simultaneously a delay chain according to Fig. 3 is created that is apt to be used for resetting each scan element in an asynchronous mode. Thus, by obtaining in the reset mode the information of a respective preceding scan input port SIₙ₋₁ with a delay at the respective scan output port SOₙ₋₁, wherein the successive scan input port SIₙ is equal to the scan output port SOₙ₋₁, the reset function is rippled through the non-inverted delay chain ensuring that each output port Q of a respective successive scan flip-flop is reset to "0" with a delay.

As can be seen from Fig. 3, such a scan chain may be implemented in an integrated circuit with the respective input ports PI₁, PI₂, PIₙ connected with response paths r of a combinational logic 100 to be tested by an automatic test pattern generator and with the respective output ports Q and QN connected with the stimuli paths s of that logic 100.

For an easy global initialization of an asynchronous reset mode using the delay chain as described above, the inventive scan flip-flop forming the first scan element of the scan chain according to Fig. 3 is provided with a further multiplexer 15 controlled by the test enable pin TE for multiplexing the input SI of the first scan element with a global external reset pin Re depending on the scan control pin TE.

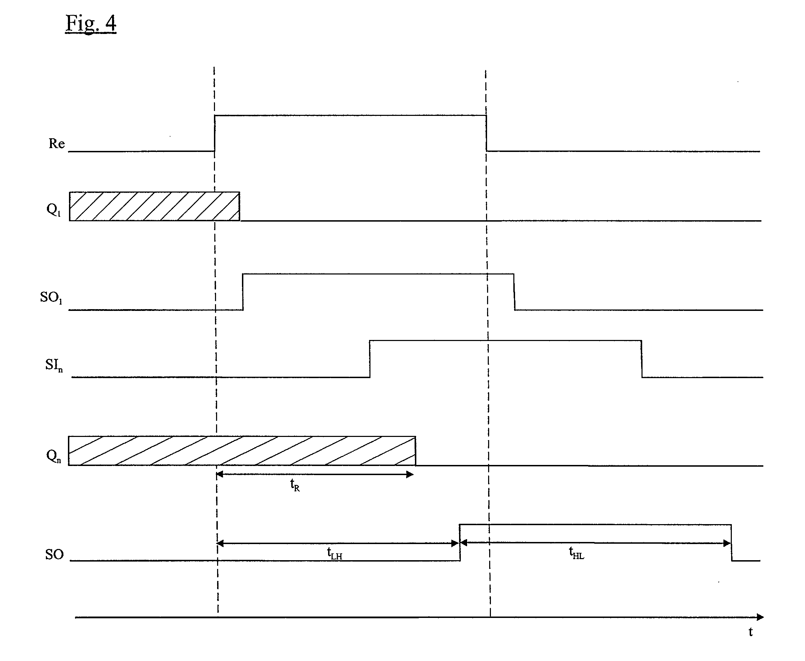

The timing behavior concerning a global reset activation by using the delay chain based on the bypass BP according to the scan chain of Fig. 3 is schematically depicted in Fig. 4. With the assumption that TE = 0, Q₁ is reset to "0" in delayed response to the setting of Re from "0" to "1". Due to the bypass BP the output port SO₁ is set to "1" with delay, causing the next scan element to be reset. Thus, a time t_{R} representing the time for performing a complete resetting of the scan chain can be determined for the output port Qₙ of the last scan element of such a scan chain. Correspondingly, a time t_{LH} and a time t_{HL} representing the times of delay measuring can be determined for the scan output pin SO associated to the last scan element of such a scan chain. Thereby, the time t_{LH} represents the time till the signal at the scan output pin SO changes from low to high in response to the reset activation and the time t_{HL} represents the time till the signal at the scan output pin SO in turn changes from high to low in response to the reset completion.

Thus, the timing diagram of Fig. 4, based on the circuit according to Fig. 3, is showing two applications, i.e. a delay measurement and a delayed global reset functionality that can be performed simultaneously.

It has to be mentioned, that by the use of the inventive scan flip-flops such a delay measurement and/or global reset activation may cover more than 300000 elements, in particular core flip-flops. A correct functional operation of the circuit according to Fig. 3 is obtained, when the reset is completely finished, since the output ports Q depend on the clock signal CLK.

However, it should be obvious for a person skilled in the art, that the delay measuring and the activation of the global resetting can be decoupled in that a separate delay chain pin is connected with the multiplexer 15 instead of the global reset pin Re, as depicted by Fig. 3.

Referring next to Fig. 2 schematically depicting a further preferred refinement comprising a scan flip-flop according to the invention and adapted to be used for an integrated circuit having at least one combinational logic 100ₓ with a different, in particular internal and/or local reset domain Riₓ.

As can be seen from Fig. 2, for resetting such a domain and/or cluster the input SIₓ of the cluster "x" is muxed with the external global reset pin Re by a multiplexer 15, wherein the external global reset pin Re in turn is coupled with the internal and/or local reset domain Riₓ for providing a reset path REₓ within the cluster "x". Moreover, for disabling during scan mode a domain resetting, i.e. for prevent an asynchronous resetting generated from the internal and/or local reset domain Riₓ, a further test reset enabling pin TRE is coupled with the reset domain Riₓ.

Thus, regarding the example, the test reset enabling pin TRE is coupled with the reset domain Riₓ by use of an AND-gate of which the output in turn is coupled with the external global reset pin Re by use of an OR-gate of which the output is providing the reset path REₓ within the cluster "x" and is muxed with the input SIₓ of the cluster "x" by the multiplexer 15, controlled by the test enable pin TE. The input Siₓ of the cluster "x" for example may be directly connected with the output SOₙ of the circuit according to Fig. 3, wherein the output SOₓ may be directly connected with the successive input port of the next cluster, i.e. to SIₓ₊₁.

Accordingly, as an option and similar to the known "carry-look-ahead" techniques, individual clusters and/or reset domains also may be bypassed to accelerate the resetting for special and/or application specific requirements, for example concerning the delay chain and/or a delayed flash clear.

Regarding a preferred implementation of the above described delayed flash clear scan flip-flops (DFC-SFF) based on a standard flip-flop 10 it is practically proposed firstly to provide a separate and non-inverted scan output port SO, secondly to implement a delay chain, in particular by use of a multiplexer 13 and thirdly to add an appropriate gate for resetting the DFC-SFF via the delay chain.

Moreover, dependent on the respective individual area and/or drive strength any user, library and/or vendor element may be created.

Subsequently, the input SI of the scan element forming the first scan element of a chain and/or cluster should be muxed with the external reset pin Re depending on the scan control pin TE. Additionally, internal and/or local reset domains Riₓ should be clustered and disabled during a scan test by use of a test reset enabling pin TRE. Finally, the synthesis with functional constraints has to be performed, wherein the scan chain routing may be performed according to standard DFT-rules.

As a consequence, the inventive approach and hence, the implementation of the inventive scan flip-flops may be seen as a new and improved standardized solution for a delayed, in particular time distributed and/or rippled reset functionality and for avoiding several problems, such as debugging efforts, design errors and/or reliability problems, caused in particular by current or even future complex ASIC/SOC designs with several 100000 and more flip-flops (e.g. all flip-flops within the ASIC) due to scan problems, for example timing, skew and/or inversion problems, and/or power-peak problems due to simultaneously switching nodes similar to flash clear problems of huge RAMs.

It should be obvious for a person skilled in the art, that even if the invention is exemplary described with regard to a global asynchronously resetting, the invention also is covering embodiments with an appropriate similar implementation enabling both the resetting and setting of the scan flip-flops, only the setting of the scan flip-flops, and/or high or low active control signals within asynchronous and/or synchronous integrated circuits.

Accordingly, the inventive approach enables an improved core scan chain implementation and handling of complex integrated circuits, a very easy delay measurement and characterization even for a very long cross-chip delay chain covering all scan flip-flops and a delayed and/or rippled global and/or local initialization, setting and/or resetting.

## Claims

1. A method for providing core scan functionality of an integrated circuit comprising the steps of:
- providing at least one scan flip-flop (10), each having a functional layer between an input port (PI) and at least one output port (Q, QN) and a storage layer between a scan input port (SI) and one of the at least one output port (Q, QN) constructed to be used within a scan chain,
- modifying said scan flip-flop 10 by adding a non-inverted and separate scan output port (SO),
- implementing each of such modified scan flip-flops in the integrated circuit by creating a scan chain using the scan input port (SI) and the scan output port (SO).

2. Method of claim 1, comprising the step of creating an additional combinational path (BP) between the scan input port (SI) and the scan output port (SO) of a respective scan flip-flop.

3. Method of claim 2, wherein the combinational path (BP) is connected to the scan output port (SO) via a multiplexer (12) controllable by a test enable pin (TE).

4. Method of any of claims of 2 to 3, comprising the step of adding a gate (14) for initiating, setting and/or resetting the modified scan flip-flop via the additional combinational path (BP).

5. Method of any of claims 1 to 4, wherein the scan input port (SI) is connected to an initialization, set and/or reset port (R).

6. Method of any of claims 1 to 5, comprising the step of analyzing the circuit to identify internal and/or local resets to be clustered and/or disabled during scan test.

7. Method of any of claims 1 to 6, comprising the step of creating a scan chain by directly connecting the scan output port (SO) of a preceding modified scan flip-flop with the scan input port (SI) of a successive modified scan flip-flop.

8. Method of any of claims 1 to 7, comprising the step of connecting the scan input (SI) of a modified first scan flip-flop with an associated reset and/or set pin (Re) via a multiplexer (15) controllable by a test enable pin (TE) .

9. Method of claim 8, comprising the step of connecting the associated reset and/or set pin (Re) with an identified internal and/or local reset domain (Riₓ) to be clustered and/or disabled during scan test by means of an associated test reset enable pin (TRE).

10. Method of any of claims 1 to 9, wherein a plurality of scan chains in parallel is provided.

11. A scan flip-flop including
an input port (PI) and at least one output port (Q, QN) with a functional layer there between,
a storage layer between a scan input port (SI) and one of the at least one output port (Q, QN) constructed to be used within a scan chain, **characterized by**
an additional and non-inverted scan output port (SO) adapted to create a scan chain passing the scan input port (SI) and the scan output port (SO).

12. Scan flip-flop of claim 11, wherein the scan flip-flop is comprising a muxed scan flip-flop wherein the input port (PI) and the scan input port (SI) are muxed via a multiplexer (11) which is controllable by a test enable pin (TE).

13. Scan flip-flop of claim 11 or 12, wherein the scan input port (SI) and the scan output port (SO) is connected by a combinational bypath (BP), with the bypath (BP) and the storage layer connected to the scan output port (SO) via an additional multiplexer (12) controlled by a test enable pin (TE).

14. Scan flip-flop of claim 13, wherein an input of the additional multiplexer (12) is connected with an inverted output port (QN) via an inverter (13)

15. Scan flip-flop of claim 13, wherein the additional multiplexer is an inverted multiplexer of which an input is connected with an inverted output port (QN).

16. Scan flip-flop of any of claims 11 to 15, wherein the scan input port (SI) and an associated reset and/or set test pin (Re) is connected via an AND-gate with a set and/or reset port (R) of the scan flip-flop.

17. Scan flip-flop of any of claims 11 to 16, wherein the scan flip-flop is adapted to form the first flip-flop of a scan chain and comprises a scan input port (SI) connected with an associated set and/or reset pin (Re) via a multiplexer (15) controllable by a test enable pin (TE).

18. Scan flip-flop of claim 17, wherein the associated set and/or reset pin (Re) is connected with an identified internal and/or local reset domain (Riₓ) to be clustered and/or disabled during scan test by means of an associated test reset enable pin (TRE).

19. Integrated circuit comprising a scan chain including at least one scan flip-flop according to any of claims 10 to 16, wherein the scan output port (SO) of a preceding scan flip-flop is directly connected with the scan input port (SI) of a successive scan flip-flop.

20. Integrated circuit of claim 19, wherein the scan input port (SI) of the scan flip-flop adapted to form a first scan flip-flop of said scan chain is connected with an associated set and/or reset pin (Re) via a multiplexer (11) controllable by the test enable pin (TE)

21. Integrated circuit of claim 20, wherein the associated set and/or reset pin (Re) is connected with an identified internal and/or local reset domain (Riₓ) to be clustered and/or disabled during scan test by means of an associated test reset enable pin (TRE).

22. Electrical device comprising an integrated circuit of any of claims 19 to 21.
